(19) Europäisches Patentamt / European Patent Office / Office européen des brevets

(11) **EP 3 306 332 A1**

(12) **EUROPEAN PATENT APPLICATION**

(43) Date of publication:
**11.04.2018 Bulletin 2018/15**

(51) Int Cl.:
**G01R 31/36** $^{(2006.01)}$

(21) Application number: **17195175.9**

(22) Date of filing: **06.10.2017**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**MA MD**<br><br>(30) Priority: **09.10.2016 CN 201610880720** | (71) Applicant: **Optimum Battery Co., Ltd.**<br>**Shenzhen City, Guangdong 518118 (CN)**<br><br>(72) Inventor: **HU, Qiu zai**<br>**Shenzhen, Guangdong 518118 (CN)**<br><br>(74) Representative: **Fry, Emma Leland et al**<br>**Greaves Brewster LLP**<br>**Copa House**<br>**Station Road**<br>**Cheddar, North Somerset BS27 3AH (GB)** |

(54) **SYSTEM AND METHOD FOR ESTIMATING PARAMETERS OF A BATTERY MODEL USING PARTICAL SWARM OPTIMISATION**

(57) A system for estimating values of parameters of a battery includes a battery management system, BMS, and a server for communicating with the BMS. The BMS includes a modeling module, an acquisition module, and a first communication module. The server includes a second communication module and an operation module. The modeling module is configured to create an equivalent circuit model for the battery. The acquisition module is configured to collect voltage and current data of the battery. The operation module is configured to use particle swarm optimization to analyze and process the collected data, to obtain optimal solutions of a plurality of parameter of the equivalent circuit model. The modeling module is further configured to update values of the parameters of the equivalent circuit model, according to the optimal solutions. The present invention further provides a method for estimating values of parameters of a battery.

**Description**

BACKGROUND OF THE INVENTION

Field of the Invention

This invention relates to electric vehicles, and more particular, to a system and method for estimating values of parameters of a battery.

Description of the Related Art

Batteries are used in a wide variety of electronic and electrical devices, such as electric vehicles. Mathematical algorithms have been utilized to estimate battery parameters, such as internal battery resistance. However, the mathematical algorithms have been unable to provide a highly accurate estimate of the battery parameters because they are not sufficiently optimized for batteries having non-linear operational characteristics.
It is desirable to provide an invention, which can overcome the problems and limitations mentioned above.

SUMMARY OF THE INVENTION

The present invention is directed to a system and method for estimating values of parameters of a battery that substantially obviates one or more of the problems due to limitations and disadvantages of the related art.
In an aspect of the present invention, there is provided a system for estimating values of parameters of a battery comprising a battery management system (BMS) and a server communicated with the BMS. The BMS comprises: a modeling module configured to create an equivalent circuit model for the battery; an acquisition module configured to collect voltage and current data of the battery; and a first communication module configured to transmit the collected data. The server comprises: a second communication module configured to receiving the collected data; and an operation module configured to use particle swarm optimization to analyze and process the collected data, to obtain optimal solutions of a plurality of parameter of the equivalent circuit model. Wherein the second communication module is further configured to transmit the optimal solutions of the parameters of the equivalent circuit model to the modeling module through the first communication module, and the modeling module is further configured to update values of the parameters of the equivalent circuit model, according to the optimal solutions.
In another aspect of the present invention, there is provided a method for estimating values of parameters of a battery comprising: creating an equivalent circuit model for the battery by a modeling module of a battery management system (BMS); collecting voltage and current data of the battery by an acquisition module of the BMS; transmitting the collected data to a server by a first communication module of the BMS; receiving the collected data by a second communication module of the server; using particle swarm optimization to analyze and process the collected data by an operation module of the server, to obtain optimal solutions of a plurality of parameter of the equivalent circuit model; transmitting the optimal solutions of the parameters of the equivalent circuit model to the modeling module through the first communication module by the second communication module; and updating values of the parameters of the equivalent circuit model by the modeling module, according to the optimal solutions.
It is to be understood that both the foregoing general description and the following detailed description are exemplary and explanatory and are intended to provide further explanations of the invention as claimed.

BRIEF DESCRIPTION OF THE DRAWINGS

Implementations of the present technology will now be described, by way of example only, with reference to the attached drawings. It may be understood that these drawings are not necessarily drawn to scale, and in no way limit any changes in form and detail that may be made to the described embodiments by one skilled in the art without departing from the spirit and scope of the described embodiments.

FIG. 1 is a block schematic diagram of a system for estimating values of parameters of a battery provided by one embodiment of the present invention, wherein the system comprises a modeling module configured to create an equivalent circuit model for the battery.
FIG. 2 is a circuit diagram of the equivalent circuit model provided by one embodiment of the present invention.
FIG. 3 is a flow chart of a method for estimating values of parameters of a battery provided by one embodiment of the present invention, wherein the method comprises block S5.
FIG. 4 a flow chart of the block S5 of Fig. 3 provided by an embodiment of the present invention.

DETAILED DESCRIPTION OF THE PREFERRED EMBODIMENTS

In order to make the purposes, technical solutions, and advantages of the present invention be clearer, the present invention will be further described in detail hereafter with reference to the accompanying drawings and embodiments. However, it will be understood by those of ordinary skill in the art that the embodiments described herein can be practiced without these specific details. In other instances, methods, procedures and components have not been described in detail so as not to obscure the related relevant feature being described. Also, it should be understood that the embodiments described herein are only intended to illustrate but not to limit the present invention.

Several definitions that apply throughout this disclosure will be presented. The term "module", as used herein, refers to logic embodied in hardware or firmware, or to a collection of software instructions, written in a programming language, such as, Java, C, or assembly. One or more software instructions in the modules can be embedded in firmware, such as in an EPROM. The modules described herein can be implemented as either software and/or hardware modules and can be stored in any type of non-transitory computer-readable medium or other storage device. Some non-limiting examples of non-transitory computer-readable media include CDs, DVDs, BLU-RAY, flash memory, and hard disk drives. The term "coupled" is defined as connected, whether directly or indirectly through intervening components, and is not necessarily limited to physical connections. The connection can be such that the objects are permanently connected or releasably connected. The term "comprise", when utilized, means "include, but not necessarily limited to"; it specifically indicates open-ended inclusion or membership in a so-described combination, group, series and the like.

It should be noted that references to "an" or "one" embodiment in this disclosure are not necessarily to the same embodiment, and such references mean "at least one."

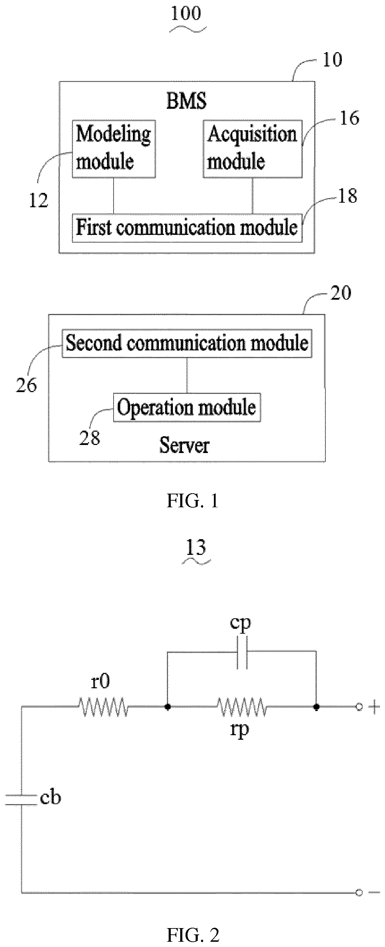

Fig. 1 illustrates a block schematic diagram of a system 100 for estimating values of parameters of a battery provided by one embodiment of the present invention. The system 100 comprises a battery management system (BMS) 10 and a server 20 communicated with the BMS 10. The BMS 10 comprises a modeling module 12, an acquisition module 16, and a first communication module 18. The server 20 comprises a second communication module 26 and an operation module 28. The first communication module 18 is electrically coupled to the modeling module 12 and the acquisition module 16. The second communication module 26 is electrically coupled to the operation module 28. The BMS 10 is communicated with the server 20 through the first communication module 18 and the second communication module 26. The first communication module 18 is communicated with the second communication module 26 through wired or wireless communication.

The modeling module 12 is configured to create an equivalent circuit model 13 for the battery shown as Fig. 2. The equivalent circuit model 13 comprises a battery capacitor cb, an internal resistor r0, a polarization resistor rp, a polarization capacitor cp, a positive output terminal +, and a negative output terminal -. The internal resistor r0 comprises a first terminal and a second terminal. The first terminal of the internal resistor r0 is electrically coupled to the negative output terminal - through the battery capacitor cb. The second terminal of the internal resistor r0 is electrically coupled to the positive output terminal + through the polarization resistor rp, and electrically coupled to the positive output terminal + through the polarization capacitor cp.

The acquisition module 16 is configured to collect voltage and current data of the battery. The first communication module 18 is configured to transmit the collected data to the server 20. The second communication module 26 is configured to receive the collected data, and output the collected data to the operation module 28. The operation module 28 is configured to use particle swarm optimization (PSO) to analyze and process the collected data, to obtain optimal solutions of a plurality of parameter of the equivalent circuit model 13. The second communication module 26 is further configured to transmit the optimal solutions of the parameters of the equivalent circuit model 13 to the first communication module 18. The first communication module 18 is further configured to receive the optimal solutions of the parameters of the equivalent circuit model 13, and output the optimal solutions of the parameters of the equivalent circuit model 13 to the modeling module 12. The modeling module 12 is further configured to update values of the parameters of the equivalent circuit model 13, according to the optimal solutions.

In one embodiment, the parameters of the equivalent circuit model 13 comprises a voltage of the battery capacitor cb, a resistance of the internal resistor r0, a resistance of the polarization resistor rp, and a capacitance of the polarization capacitor cp. A relationship between the voltage and the current collected by the acquisition module 16 complied with the following equation:

$$U(t) = Uocv - I(t) * R_0 - I(t) * R_P(1 - \exp(-\frac{t}{R_P C_P})) \quad \text{(equation 1),}$$

(equation 1),

wherein t represents time, U(t) represents the voltage collected by the acquisition module 16 at time t, I(t) represents the current collected by the acquisition module 16 at time t, Uocv represents the voltage of the battery capacitor cb, Ro represents the resistance of the internal resistor r0, Rp represents the resistance of the polarization resistor rp, and Cp

represents the capacitance of the polarization capacitor cp.

The voltage of the battery capacitor cb, the resistance of the internal resistor r0, the resistance of the polarization resistor rp, and the capacitance of the polarization capacitor cp of the equivalent circuit model 13 are defined as variables to be solved, and further defined as dimension elements of position X of the PSO by the operation module 28. A relationship between the position X of the PSO and the voltage of the battery capacitor cb, the resistance of the internal resistor r0, the resistance of the polarization resistor rp, and the capacitance of the polarization capacitor cp of the equivalent circuit model 13 complied with the following equation: X=[Uocv, Ro, Rp, Cp].

A function P= $\sum$ (U'(t)-V(t))^2 is defined by the operation module 28, wherein U'(t) represents a voltage of the battery calculated by the modeling module 12 at time t, based on the equation 1, and V(t) represents a voltage of the battery collected by the acquisition module 16 at time t. An objective of the PSO is to find an optimal solution combination Xbest that minimizes value of the function P. Xbest=[ Uocvbest, Robest, Rpbest, Cpbest], wherein Uocvbest represents an optimal solution of the voltage of the battery capacitor cb, Robest represents an optimal solution of the resistance of the internal resistor r0, Rpbest represents an optimal solution of the resistance of the polarization resistor rp, and Cpbest represents an optimal solution of the capacitance of the polarization capacitor cp.

The operation module 28 is further configured to initialize a group of random particles, and find an optimal solution for each particle by iteration. Specifically, the operation module 28 is further configured to update a speed and a position of each particle by tracking a first extreme value and a second extreme value. The first extreme value is the optimal solution of a corresponding particle, and the second extreme value is the optimal solution of the group of random particles. the operation module 28 updates the speed and the position of each particle by the following equation:

$$v[k+1]=w*v[k]+c1*rand*(pbest[k]-x[k])+c2*rand*(gbest[k]-x[k]),$$

$$x[k+1]=x[k]+v[k+1],$$

wherein v[k+1] represents a speed of the particle at time k+1, v[k] represents a speed of the particle at time k, w represents an inertia weight, c1 represents a first learning factor, c2 represents a second learning factor, rand represents a random number between (0,1), pbest[k] represents the optimal solution of the particle at time k, gbest[k] represents the optimal solution of the group of random particles at time k, x[k] represents a position of the particle at time k, and x[k+1] represents a position of the particle at time k+1.

It may understood that, the server 20 can further comprises a plurality of processors, a plurality of hard disks, and a plurality of memories. The server 20 is similar to a general-purpose computer, but the server 20 has a high processing capability, stability, reliability, security, and scalability. Therefore, the server 20 can calculate the optimal solutions of the parameters of the equivalent circuit model 13 quickly and accurately; and a problem that the BMS 10 cannot calculate the optimal solutions of the parameters of the equivalent circuit model 13, because computing speed and memory capacity of the BMS 10 is limited, is solved.

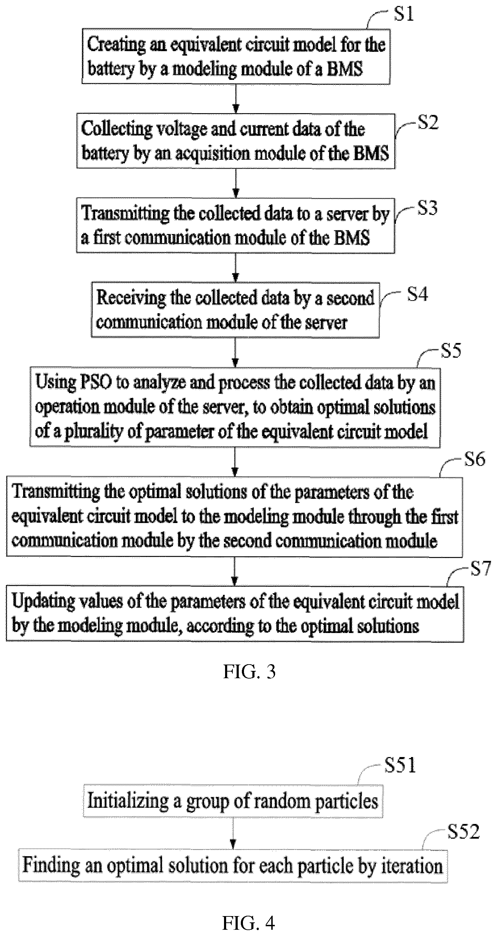

Fig. 3 illustrates a flow chart of a method for estimating values of parameters of a battery provided by an embodiment of the present invention. Each block shown in FIG. 3 represents one or more processes, methods, or subroutines, carried out in the method for estimating values of parameters of a battery. Depending on the embodiment, additional blocks can be added, others removed, and the illustrated order of blocks is by example only and the order of the blocks can change. The method for estimating values of parameters of a battery can begin at block S 1.

At block S1, creating an equivalent circuit model 13 for the battery by a modeling module 12 of a battery management system (BMS) 10.

In one embodiment, the equivalent circuit model 13 (shown as Fig. 2) comprises a battery capacitor cb, an internal resistor r0, a polarization resistor rp, a capacitance of the polarization capacitor cp, a positive output terminal +, and a negative output terminal -. The internal resistor r0 comprises a first terminal and a second terminal. The first terminal of the internal resistor r0 is electrically coupled to the negative output terminal - through the battery capacitor cb. The second terminal of the internal resistor r0 is electrically coupled to the positive output terminal + through the polarization resistor rp, and electrically coupled to the positive output terminal + through the polarization capacitor cp.

At block S2, collecting voltage and current data of the battery by an acquisition module 16 of the BMS 10.

At block S3, transmitting the collected data to a server 20 by a first communication module 18 of the BMS 10.

At block S4, receiving the collected data by a second communication module 26 of the server 20.

At block S5, using particle swarm optimization (PSO) to analyze and process the collected data by an operation module 28 of the server 20, to obtain optimal solutions of a plurality of parameter of the equivalent circuit model 13.

In one embodiment, the parameters of the equivalent circuit model 13 comprises a voltage of the battery capacitor cb, a resistance of the internal resistor r0, a resistance of the polarization resistor rp, and a capacitance of the polarization capacitor cp. A relationship between the voltage and the current collected by the acquisition module 16

complied with the following equation:

$$U(t) = Uocv - I(t) * R_0 - I(t) * R_P(1 - \exp(-\frac{t}{R_P C_P}))$$ (equation 1),

(equation 1),

wherein t represents time, U(t) represents the voltage collected by the acquisition module 16 at time t, I(t) represents the current collected by the acquisition module 16 at time t, Uocv represents the voltage of the battery capacitor cb, Ro represents the resistance of the internal resistor r0, Rp represents the resistance of the polarization resistor rp, and Cp represents the capacitance of the polarization capacitor cp.

The voltage of the battery capacitor cb, the resistance of the internal resistor r0, the resistance of the polarization resistor rp, and the capacitance of the polarization capacitor cp of the equivalent circuit model 13 are defined as variables to be solved, and further defined as dimension elements of position X of the PSO by the operation module 28. A relationship between the position X of the PSO and the voltage of the battery capacitor cb, the resistance of the internal resistor r0, the resistance of the polarization resistor rp, and the capacitance of the polarization capacitor cp of the equivalent circuit model 13 complied with the following equation:

$$X=[Uocv, R_0, Rp, Cp].$$

A function $P= \sum (U'(t)-V(t))^2$ is defined by the operation module 28, wherein U'(t) represents a voltage of the battery calculated by the modeling module 12 at time t, based on the equation 1, and V(t) represents the voltage of the battery collected by the acquisition module 16 at time t. An objective of the PSO is to find an optimal solution combination Xbest that minimizes value of the function P. Xbest=[ Uocvbest, Robest, Rpbest, Cpbest], wherein Uocvbest represents an optimal solution of the voltage of the battery capacitor cb, Robest represents an optimal solution of the resistance of the internal resistor r0, Rpbest represents an optimal solution of the resistance of the polarization resistor rp, and Cpbest represents an optimal solution of the capacitance of the polarization capacitor cp.

Fig. 4 illustrates a flow chart of the block S5 provided by an embodiment of the present invention. Each block shown in FIG. 4 represents one or more processes, methods, or subroutines, carried out in "using particle swarm optimization (PSO) to analyze and process the collected data". Depending on the embodiment, additional blocks can be added, others removed, and the illustrated order of blocks is by example only and the order of the blocks can change. Using the PSO to analyze and process the collected data can begin at block S51.

At block S51, initializing a group of random particles.

At block S52, finding an optimal solution for each particle by iteration.

In one embodiment, "finding an optimal solution for each particle by iteration" comprises updating a speed and a position of each particle by tracking a first extreme value and a second extreme value. The first extreme value is the optimal solution of a corresponding particle, and the second extreme value is the optimal solution of the group of random particles.

In one embodiment, "finding an optimal solution for each particle by iteration" further comprises updating the speed and the position of each particle by the following equation:

$$v[k+1]=w*v[k]+c1*rand*(pbest[k]-x[k])+c2*rand*(gbest[k]-x[k]),$$

$$x[k+1]=x[k]+v[k+1],$$

wherein v[k+1] represents a speed of the particle at time k+1, v[k] represents a speed of the particle at time k, w represents an inertia weight, c1 represents a first learning factor, c2 represents a second learning factor, rand represents a random number between (0,1), pbest[k] represents the optimal solution of the particle at time k, gbest[k] represents the optimal solution of the group of random particles at time k, x[k] represents a position of the particle at time k, and x[k+1] represents a position of the particle at time k+1.

At block S6, transmitting the optimal solutions of the parameters of the equivalent circuit model 13 to the BMS 10 by a second communication module 26 of the server 20.

At block S7, updating values of the parameters of the equivalent circuit model 13 by the modeling module 12, according to the optimal solutions.

As detail above, the BMS 10 is configured to create an equivalent circuit model 13 for the battery, collect voltage and current data of the battery, and transmit the collected data to the server 20. The server 20 with high processing capability, stability, reliability, security, and scalability, is configured to calculate the optimal solutions of the parameters of the equivalent circuit model 13 quickly and accurately, according to the collected data, and transmit the optimal solutions of the parameters of the equivalent circuit model 13 to the modeling module 12. Therefore, the values of the parameters of the equivalent circuit model 13 can be updated online by the modeling module 12, according to the optimal solutions; and the values of the parameters of the battery estimated by the system 100 can be more accurately.

It will be apparent to those skilled in the art that various modification and variations can be made in the multicolor illumination device and related method of the present invention without departing from the spirit or scope of the invention. Thus, it is intended that the present invention cover modifications and variations that come within the scope of the appended claims and their equivalents.

**Claims**

1. A system (100) for estimating values of parameters of a battery, comprising:

   a battery management system (BMS) (10) comprising:

   a modeling module (12) configured to create an equivalent circuit model (13) for the battery;
   an acquisition module (16) configured to collect voltage and current data of the battery; and
   a first communication module (18) configured to transmit the collected data; and

   a server (20) communicated with the BMS (10), the server (20) comprising:

   a second communication module (26) configured to receiving the collected data; and
   an operation module (28) configured to use particle swarm optimization (PSO) to analyze and process the collected data, to obtain optimal solutions of a plurality of parameter of the equivalent circuit model (13);

   wherein the second communication module (26) is further configured to transmit the optimal solutions of the parameters of the equivalent circuit model (13) to the modeling module (12) through the first communication module (18), and the modeling module (12) is further configured to update values of the parameters of the equivalent circuit model (13), according to the optimal solutions.

2. The system (100) for estimating values of parameters of a battery of claim 1, wherein the equivalent circuit model (13) comprises a battery capacitor (cb), an internal resistor (r0), a polarization resistor (rp), a polarization capacitor (cp), a positive output terminal (+), and a negative output terminal (-); the internal resistor (r0) comprises a first terminal electrically coupled to the negative output terminal (-) through the battery capacitor (cb), and a second terminal electrically coupled to the positive output terminal (+) through the polarization resistor (rp), and electrically coupled to the positive output terminal (+) through the polarization capacitor (cp).

3. The system (100) for estimating values of parameters of a battery of claim 2, wherein the parameters of the equivalent circuit model (13) comprises a voltage of the battery capacitor (cb), a resistance of the internal resistor (r0), a resistance of the polarization resistor (rp), and a capacitance of the polarization capacitor (cp).

4. The system (100) for estimating values of parameters of a battery of claim 3, a relationship between the voltage and the current collected by the acquisition module (16) complied with the following equation:

$$\mathrm{U}(t) = Uocv - I(t) * R_0 - I(t) * R_P\left(1 - \exp\left(-\frac{t}{R_P C_P}\right)\right) (\text{equation 1}),$$

wherein t represents time, U(t) represents the voltage collected by the acquisition module (16) at time t, I(t) represents the current collected by the acquisition module (16) at time t, Uocv represents the voltage of the battery capacitor (cb), (Ro) represents the resistance of the internal resistor (r0), (Rp) represents the resistance of the polarization resistor (rp), and (Cp) represents the capacitance of the polarization capacitor (cp).

5. The system (100) for estimating values of parameters of a battery of claim 4, wherein the voltage of the battery capacitor (cb), the resistance of the internal resistor (r0), the resistance of the polarization resistor (rp), and the capacitance of the polarization capacitor (cp) of the equivalent circuit model (13) are defined as variables to be solved, and further defined as dimension elements of position X of the PSO by the operation module (28);

wherein a relationship between the position X of the PSO and the voltage of the battery capacitor (cb), the resistance of the internal resistor (r0), the resistance of the polarization resistor (rp), and the capacitance of the polarization capacitor (cp) of the equivalent circuit model (13) complied with the following equation:

$$X=[Uocv, R_0, Rp, Cp].$$

6. The system (100) for estimating values of parameters of a battery of claim 5, wherein a function $P= \sum (U'(t)-V(t))^2$ is defined by the operation module (28), U'(t) represents a voltage of the battery calculated by the modeling module (12) at time t, based on the equation 1, and V(t) represents a voltage of the battery collected by the acquisition module (16) at time t; and

wherein an objective of the PSO is to find an optimal solution combination Xbest that minimizes value of the function P, Xbest=[Uocvbest, Robest, Rpbest, Cpbest], Uocvbest represents an optimal solution of the voltage of the battery capacitor (cb), Robest represents an optimal solution of the resistance of the internal resistor (r0), Rpbest represents an optimal solution of the resistance of the polarization resistor (rp), and Cpbest represents an optimal solution of the capacitance of the polarization capacitor (cp).

7. The system (100) for estimating values of parameters of a battery of claim 6, wherein the operation module (28) is further configured to initialize a group of random particles, and find an optimal solution for each particle by iteration.

8. The system (100) for estimating values of parameters of a battery of claim 7, wherein the operation module (28) is further configured to update a speed and a position of each particle by tracking a first extreme value and a second extreme value; the first extreme value is the optimal solution of a corresponding particle, and the second extreme value is the optimal solution of the group of random particles.

9. The system (100) for estimating values of parameters of a battery of claim 8, wherein the operation module (28) updates the speed and the position of each particle by the following equation:

$$v[k+1]=w*v[k]+c1*rand*(pbest[k]-x[k])+c2*rand*(gbest[k]-x[k]),$$

$$x[k+1]=x[k]+v[k+1],$$

wherein v[k+1] represents a speed of the particle at time k+1, v[k] represents a speed of the particle at time k, w represents an inertia weight, c1 represents a first learning factor, c2 represents a second learning factor, rand represents a random number between (0,1), pbest[k] represents the optimal solution of the particle at time k, gbest[k] represents the optimal solution of the group of random particles at time k, x[k] represents a position of the particle at time k, and x[k+1] represents a position of the particle at time k+1.

10. The system (100) for estimating values of parameters of a battery of claim 1, wherein the first communication module (18) is communicated with the second communication module (26) through wired or wireless communication.

11. A method for estimating values of parameters of a battery, comprising:

creating an equivalent circuit model (13) for the battery by a modeling module (12) of a battery management system (BMS) (10);
collecting voltage and current data of the battery by an acquisition module (16) of the BMS (10);
transmitting the collected data to a server (20) by a first communication module (18) of the BMS (10);
receiving the collected data by a second communication module (26) of the server (20);
using particle swarm optimization (PSO) to analyze and process the collected data by an operation module (28) of the server (20), to obtain optimal solutions of a plurality of parameter of the equivalent circuit model (13);
transmitting the optimal solutions of the parameters of the equivalent circuit model (13) to the modeling module (12) through the first communication module (18) by the second communication module (26); and
updating values of the parameters of the equivalent circuit model (13) by the modeling module (12), according to the optimal solutions.

12. The method for estimating values of parameters of a battery of claim 11, wherein the equivalent circuit model (13) comprises a battery capacitor (cb), an internal resistor (r0), a polarization resistor (rp), a polarization capacitor (cp), a positive output terminal (+), and a negative output terminal (-); the internal resistor (r0) comprises a first terminal electrically coupled to the negative output terminal (-) through the battery capacitor (cb), and a second terminal electrically coupled to the positive output terminal (+) through the polarization resistor (rp), and electrically coupled to the positive output terminal (+) through the polarization capacitor (cp).

13. The method for estimating values of parameters of a battery of claim 12, wherein the parameters of the equivalent circuit model (13) comprises an voltage of the battery capacitor (cb), an resistance of the internal resistor (r0), a resistance of the polarization resistor (rp), and a capacitance of the polarization capacitor (cp).

14. The method for estimating values of parameters of a battery of claim 13, a relationship between the voltage and the current collected by the acquisition module (16) complied with the following equation:

$$\text{U}(t) = Uocv - I(t) * R_0 - I(t) * R_p\left(1 - \exp\left(-\frac{t}{R_P C_P}\right)\right) \text{(equation 1)},$$

wherein t represents time, U(t) represents the voltage collected by the acquisition module (16) at time t, I(t) represents the current collected by the acquisition module (16) at time t, Uocv represents the voltage of the battery capacitor (cb), Ro represents the resistance of the internal resistor (r0), Rp represents the resistance of the polarization resistor (rp), and Cp represents the capacitance of the polarization capacitor (cp).

15. The method for estimating values of parameters of a battery of claim 14, wherein the voltage of the battery capacitor (cb), the resistance of the internal resistor (r0), the resistance of the polarization resistor (rp), and the capacitance of the polarization capacitor (cp) of the equivalent circuit model (13) are defined as variables to be solved, and further defined as dimension elements of position X of the PSO by the operation module (28);

wherein a relationship between the position X of the PSO and the voltage of the battery capacitor (cb), the resistance of the internal resistor (r0), the resistance of the polarization resistor (rp), and the capacitance of the polarization capacitor (cp) of the equivalent circuit model (13) complied with the following equation:

$$X=[Uocv, R_0, Rp, Cp].$$

16. The method for estimating values of parameters of a battery of claim 15, wherein a function P= $\sum$ (U'(t)-V(t))^2 is defined by the operation module (28), U'(t) represents a voltage of the battery calculated by the modeling module (12) at time t, and V(t) represents the voltage of the battery collected by the acquisition module (16) at time t; and wherein an objective of the PSO is to find an optimal solution combination Xbest that minimizes value of the function P, Xbest=[Uocvbest, Robest, Rpbest, Cpbest], Uocvbest represents an optimal solution of the voltage of the battery capacitor (cb), Robest represents an optimal solution of the resistance of the internal resistor (r0), Rpbest represents an optimal solution of the resistance of the polarization resistor (rp), and Cpbest represents an optimal solution of the capacitance of the polarization capacitor (cp).

17. The method for estimating values of parameters of a battery of claim 16, wherein "using particle swarm optimization (PSO) to analyze and process the collected data" comprises:

initializing a group of random particles; and
finding an optimal solution for each particle by iteration.

18. The method for estimating values of parameters of a battery of claim 17, wherein "finding an optimal solution for each particle by iteration" comprises:

updating a speed and a position of each particle by tracking a first extreme value and a second extreme value; and wherein the first extreme value is the optimal solution of a corresponding particle, and the second extreme value is the optimal solution of the group of random particles.

19. The method for estimating values of parameters of a battery of claim 18, wherein "finding an optimal solution for each particle by iteration" further comprises:

updating the speed and the position of each particle by the following equation:

$$v[k+1]=w*v[k]+c1*rand*(pbest[k]-x[k])+c2*rand*(gbest[k]-x[k]),$$

$$x[k+1]=x[k]+v[k+1],$$

wherein v[k+1] represents a speed of the particle at time k+1, v[k] represents a speed of the particle at time k, w represents an inertia weight, c1 represents a first learning factor, c2 represents a second learning factor, rand represents a random number between (0,1), pbest[k] represents the optimal solution of the particle at time k, gbest[k] represents the optimal solution of the group of random particles at time k, x[k] represents a position of the particle at time k, and x[k+1] represents a position of the particle at time k+1.

20. The method for estimating values of parameters of a battery of claim 11, wherein the first communication module (18) is communicated with the second communication module (26) through wired or wireless communication.

100

10

## BMS

| Modeling module | Acquisition module |
| --- | --- |

12 16

| First communication module | 18 |
| --- | --- |

20

## Server

| Second communication module |
| --- |

26

| Operation module |
| --- |

28

FIG. 1

13

FIG. 2

```
                                                            ┌─ S1
        ┌──────────────────────────────────────┐
        │ Creating an equivalent circuit model for the │
        │ battery by a modeling module of a BMS        │
        └──────────────────────────────────────┘
                          │
                          ▼                          ┌─ S2
        ┌──────────────────────────────────┐
        │ Collecting voltage and current data of the │
        │ battery by an acquisition module of the BMS │
        └──────────────────────────────────┘
                          │
                          ▼                          ┌─ S3
        ┌──────────────────────────────────┐
        │ Transmitting the collected data to a server by │
        │ a first communication module of the BMS        │
        └──────────────────────────────────┘
                          │
                          ▼                          ┌─ S4
        ┌──────────────────────────────────┐
        │ Receiving the collected data by a second │
        │ communication module of the server       │
        └──────────────────────────────────┘
                          │
                          ▼                                ┌─ S5
        ┌──────────────────────────────────────────┐
        │ Using PSO to analyze and process the collected data by an │
        │ operation module of the server, to obtain optimal solutions │
        │ of a plurality of parameter of the equivalent circuit model │
        └──────────────────────────────────────────┘
                          │
                          ▼                                ┌─ S6
        ┌──────────────────────────────────────────┐
        │ Transmitting the optimal solutions of the parameters of the │
        │ equivalent circuit model to the modeling module through the first │
        │ communication module by the second communication module │
        └──────────────────────────────────────────┘
                          │
                          ▼                                ┌─ S7
        ┌──────────────────────────────────────────┐
        │ Updating values of the parameters of the equivalent circuit model │
        │ by the modeling module, according to the optimal solutions │
        └──────────────────────────────────────────┘
```

FIG. 3

```
                                                    ┌─ S51
        ┌──────────────────────────────────┐
        │ Initializing a group of random particles │
        └──────────────────────────────────┘
                          │                        ┌─ S52
                          ▼
        ┌──────────────────────────────────────────┐
        │ Finding an optimal solution for each particle by iteration │
        └──────────────────────────────────────────┘
```

FIG. 4

Europäisches
Patentamt

European
Patent Office

Office européen
des brevets

# EUROPEAN SEARCH REPORT

Application Number

EP 17 19 5175

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2016/082208 A1 (BOSCH GMBH ROBERT [DE]; ZHANG MINGLIANG [CN]) 2 June 2016 (2016-06-02) * figures 1-3,5 * * claims 1,4-8,10 * * page 1, paragraph 4 - page 2, paragraph 2 * * page 3, paragraph 9 - page 4, paragraph 1 * * page 5, paragraph 2 - page 10, paragraph 2 * | 1-20 | INV. G01R31/36 |
| Y | CN 103 793 605 A (ZHEJIANG MEASUREMENT SCIENCE RES INST) 14 May 2014 (2014-05-14) * abstract * * figure 1 * * paragraph [0053] - paragraph [0091] * | 1-20 | |
| A | DE 10 2012 016279 A1 (DAIMLER AG [DE]) 7 March 2013 (2013-03-07) * the whole document * | 1-20 | |
| A | US 2014/088897 A1 (SHARMA RATNESH [US] ET AL) 27 March 2014 (2014-03-27) * the whole document * | 1-20 | TECHNICAL FIELDS SEARCHED (IPC) G01R G06N |
| A | CN 105 717 460 A (UNIV SHENZHEN) 29 June 2016 (2016-06-29) * the whole document * | 1-20 | |
| A | CN 105 842 627 A (BEIJING INST TECHNOLOGY) 10 August 2016 (2016-08-10) * the whole document * | 1-20 | |

-/--

The present search report has been drawn up for all claims

| Place of search | Date of completion of the search | Examiner |
|---|---|---|
| Munich | 15 February 2018 | Nguyen, Minh |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 17 19 5175

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HUACHUN HAN ET AL: "State of Charge estimation of Li-ion battery in EVs based on second-order sliding mode observer", 2014 IEEE CONFERENCE AND EXPO TRANSPORTATION ELECTRIFICATION ASIA-PACIFIC (ITEC ASIA-PACIFIC), IEEE, 31 August 2014 (2014-08-31), pages 1-5, XP032671970, DOI: 10.1109/ITEC-AP.2014.6941100 [retrieved on 2014-10-31] * the whole document * ----- | 1-20 | |

TECHNICAL FIELDS
SEARCHED      (IPC)

The present search report has been drawn up for all claims

| Place of search | Date of completion of the search | Examiner |
|---|---|---|
| Munich | 15 February 2018 | Nguyen, Minh |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

page 2 of 2

## ANNEX TO THE EUROPEAN SEARCH REPORT
## ON EUROPEAN PATENT APPLICATION NO.

EP 17 19 5175

This annex lists the patent family members relating to the patent documents cited in the above-mentioned European search report.
The members are as contained in the European Patent Office EDP file on
The European Patent Office is in no way liable for these particulars which are merely given for the purpose of information.

15-02-2018

| Patent document cited in search report | | Publication date | Patent family member(s) | | | Publication date |
|---|---|---|---|---|---|---|
| WO 2016082208 | A1 | 02-06-2016 | CN | 107003357 | A | 01-08-2017 |
| | | | EP | 3224632 | A1 | 04-10-2017 |
| | | | JP | 2017538935 | A | 28-12-2017 |
| | | | KR | 20170092552 | A | 11-08-2017 |
| | | | US | 2017328956 | A1 | 16-11-2017 |
| | | | WO | 2016082208 | A1 | 02-06-2016 |
| CN 103793605 | A | 14-05-2014 | NONE | | | |
| DE 102012016279 | A1 | 07-03-2013 | NONE | | | |
| US 2014088897 | A1 | 27-03-2014 | NONE | | | |
| CN 105717460 | A | 29-06-2016 | NONE | | | |
| CN 105842627 | A | 10-08-2016 | NONE | | | |

EPO FORM P0459

For more details about this annex : see Official Journal of the European Patent Office, No. 12/82